## Europäisches Patentamt
## European Patent Office
## Office européen des brevets

(11) Veröffentlichungsnummer: **0 045 347**
**A1**

(12) **EUROPÄISCHE PATENTANMELDUNG**

(21) Anmeldenummer: **81102192.2**

(22) Anmeldetag: **24.03.81**

(51) Int. Cl.³: **A 47 B 81/06**
**H 05 K 7/18**

(30) Priorität: **31.07.80 DE 8020557 U**

(43) Veröffentlichungstag der Anmeldung:
**10.02.82 Patentblatt 82/6**

(84) Benannte Vertragsstaaten:
**AT BE CH FR GB IT LI LU NL SE**

(71) Anmelder: **Esslinger, Hartmut**
**Grenzweg 33**
**D-7272 Altensteig(DE)**

(72) Erfinder: **Esslinger, Hartmut**
**Grenzweg 33**
**D-7272 Altensteig(DE)**

(74) Vertreter: **Vogel, Georg**
**Hermann-Essig-Strasse 35**
**D-7141 Schwieberdingen(DE)**

(54) **Einbaumöbel für die Geräte einer Hifi-Stereoanlage oder dgl.**

(57) Die Erfindung betrifft ein Einbaumöbel für die Geräte einer Hifi-Stereoanlage oder dgl. Um die Geräte in einem Schrankfach, einer Schrankwand oder dgl. so unterzubringen, daß sie bequem zu handhaben sind, insbesondere einfach elektrisch miteinander zu verbinden und wieder zu trennen, wird nach der Erfindung ein zur Vorder- und Rückseite hin offener, in Boxen unterteilter Möbelrahmen (10) verwendet, der im Bereich einer vertikalen Vorderkante unten und oben mit Schwenkbeschlägen (13,36) versehen ist.

Fig.1

EP 0 045 347 A1

- 1 -

Einbaumöbel für die Geräte einer
Hifi-Stereoanlage oder dgl.

Die Erfindung betrifft ein Einbaumöbel für die Geräte einer Hifi-Stereoanlage oder dgl.

Eine derartige Anlage umfaßt mehrere Geräte, wie Tuner, Verstärker, Magnetband-Kassettenrecorder, Plattenspieler usw. Diese Geräte werden heute üblicherweise einzeln oder übereinander gestellt in Schrankfächern oder dgl. einer Schrankwand oder dgl. abgestellt.

Diese Art der Unterbringung in einer Schrankwand oder dgl. ist nicht befriedigend.

Es ist Aufgabe der Erfindung, ein Einbaumöbel zu schaffen, das alle für eine Hifi-Stereoanlage oder dgl. erforderlichen Geräte aufnehmen kann und das in ein Schrankfach einer Schrankwand oder dgl. eingebaut werden kann.

Diese Aufgabe wird nach der Erfindung dadurch gelöst, daß ein zur Vorder- und Rückseite hin offener, in Boxen unterteilter Möbelrahmen im Bereich einer vertikalen Vorderkante oben und unten mit Schwenkbeschlägen versehen ist.

- 2 -

Der zur Vorder- und Rückseite hin offene Möbelrahmen stellt eine Art Regal mit mehreren Boxen dar, in die die Geräte eingestellt werden können. Dabei ist es von Vorteil, wenn die Ausgestaltung so ist, daß zumindest die Abstellplatten lösbar mit der Seitenplatte verbunden und in unterschiedlichen Abtänden mit der Seitenplatte verbindbar sind. Die Boxen lassen sich dann leicht an die Größe der unterzubringenden Geräte anpassen. Mit den Schwenkbeschlägen kann das Einbaumöbel schwenkbar in ein Schrankfach oder dgl. einer Schrankwand oder dgl. eingebaut werden. Da die Schwenkachse im Bereich einer vertikalen Vorderkante gewählt ist, läßt sich der Möbelrahmen voll ausschwenken. Die Rückseite der eingestellten Geräte ist daher leicht zugänglich, was für die Verbindung der Geräte untereinander und ihren Anschluß an die Stromversorgung ein wesentlicher Vorteil ist.

Das erfindungsgemäße Einbaumöbel ist nach einer einfachen Ausgestaltung so ausgeführt, daß der Möbelrahmen aus mindestens einer Seitenplatte im Bereich der Schwenkbeschläge, einer Bodenplatte und mehreren, im Abstand übereinander angeordneten Abstellplatten gebildet ist.

Da das Einbaumöbel aus dem Schrankfach ausgeschwenkt werden können muß, dürfen die Geräte nicht die volle Breite des Schrankfaches belegen. Dazu ist dann vorgesehen, daß die Bodenplatte und die Abstellplatten an der Seitenplatte befestigt sind und daß die Bodenplatte und die Abstellplatten an der Vorderseite beidseitig mittels vertikaler Seitenblenden teilweise abgedeckt sind. Die Seitenblende im Bereich der Schwenkachse kann durchaus bis zur Seitenplatte reichen, da diese die Schwenkbewegung nicht beeinträchtigt. Die Auslegung kann daher so gewählt werden, daß die Seitenplatte an der Außenkante der zugekehrten Seitenblende befestigt ist und daß die Schwenkbeschläge auf Befestigungsplatten angebracht sind, die im Eckbereich zwischen der Seitenplatte und der Seitenblende angeordnet sind.

Die der Schwenkachse abgekehrte Seitenblende steht dagegen über die Enden der Bodenplatte und der Abstellplatten vor. Die Seitenblende reicht dabei bis zur Seitenwand des Schrankfaches. Die im Abstand zu dieser Seitenwand endenden Abstellplatten behindern dann das Ausschwenken des Einbaumöbels aus dem Schrankfach nicht. Selbstverständlich können die der Schwenkachse abgekehrten Enden der Bodenplatte und der Abstellplatten auch entsprechend dem Schwenkradius abgerundet sein.

Es liegt auch im Rahmen der Erfindung, daß die der Schwenkachse abgekehrten Enden der Bodenplatte und der Abstellplatten mit einer weiteren Seitenplatte befestigt sind und daß an der Stirnfläche dieser Seitenplatte die zugekehrte Seitenblende mit dem Bereich ihrer Innenkante befestigt ist.

Eine zusätzliche Abstützung des Einbaumöbels im Schrankfach bei der Schwenkbewegung läßt sich nach einer weiteren Ausgestaltung dadurch erreichen, daß die Bodenplatte auf der der Schwenkachse abgekehrten Seite an der Unterseite im Bereich der hinteren Kante eine Laufrolle oder dgl. trägt.

Die Bedienung des Einbaumöbels wird dadurch erleichtert, daß die der Schwenkachse abgekehrte Seitenblende über die Enden der Bodenplatte und der Abstellplatten vorsteht. DAs Griffstück ist dabei vorzugsweise im unteren Bereich der Seitenblende angebracht.

Der Anschluß der in die Boxen des Möbelrahmens eingestellten Geräte wird nach einer Ausgestaltung dadurch erleichtert, daß die Seiten-

- 4 -

platte an der Rückseite über die durch den Möbelrahmen gebildeten Boxen vorsteht und auf der den Boxen zugekehrten Innenseiten eine Mehrfachsteckdose trägt.

Um eine bündige Vorderfront zwischen den eingestellten Geräten und dem Einbaumöbel zu erhalten, sieht eine Ausgestaltung vor, daß die vorderen Stirnflächen der Bodenplatte und der Abstellplatten zwischen den Seitenblenden mittels Profilleisten abgedeckt sind.

Der obere Abschluß wird dadurch erreicht, daß die beiden Seitenblenden an ihren oberen Enden mittels einer Gitterleiste oder dgl. verbunden sind, die die obere Box abteilt. Diese Gitterleiste stellt nicht nur den bündigen Abschluß nach oben her, sondern bringt auch eine Belüftung für die eingestellten Geräte.

Die Erfindung wird anhand eines in den Zeichnungen dargestellten Ausführungsbeispiels näher erläutert. Es zeigt:

Fig. 1 in perspektivischer Ansicht ein Einbaumöbel nach der Erfindung mit vier eingestellten Geräten,

Fig. 2 eine vergrößerte Vorderansicht des in ein Schrankfach eingebauten Einbaumöbels und

Fig. 3 eine Seitenansicht des in das Schrankfach eingebauten Einbaumöbels.

- 5 -

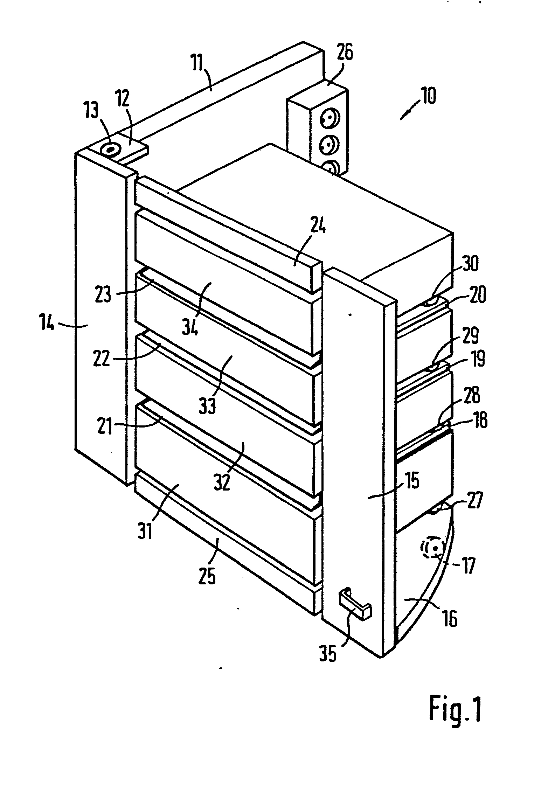

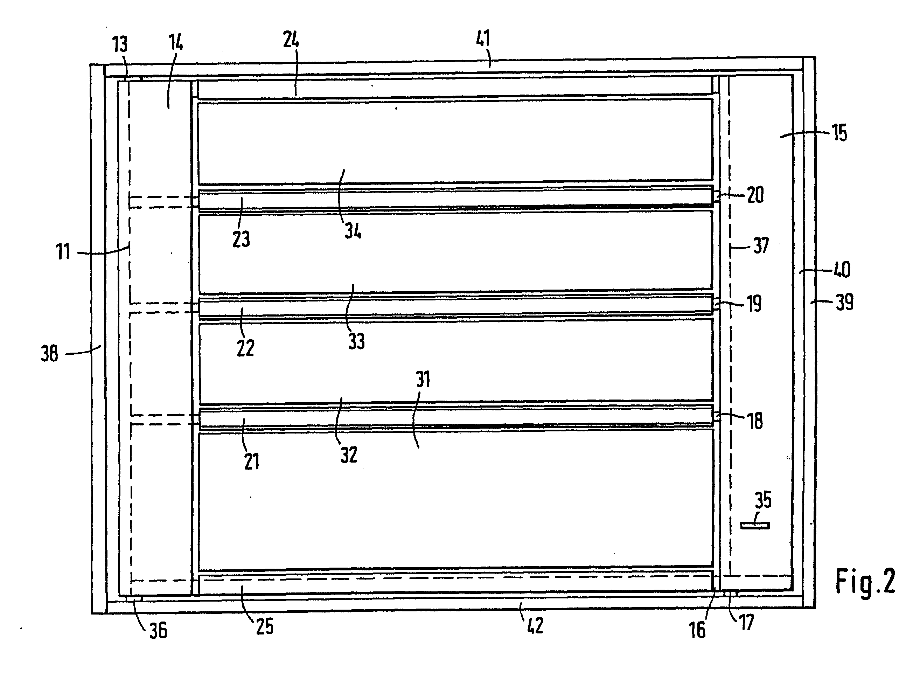

Das in Fig. 1 gezeigte Einbaumöbel nach der Erfindung besteht im wesentlichen aus einem Möbelrahmen 10, der zur Vorder- und Rückseite hin offen ist und mehrere Boxen zum Einstellen von Geräten bildet. Dieser Möbelrahmen 10 besteht aus der vertikalen Seitenplatte 11 an der linken Seite des Einbaumöbels. An dieser Seitenplatte 11 sind die Bodenplatte 16 und die übereinander angeordneten, die Boxen abteilenden Abstellplatten 18,19 und 20 befestigt. An der Vorderseite des Einbaumöbels decken die vertikalen Seitenblenden 14 und 15 die Bodenplatte 16 und die Abstellplatten 18,19 und 20 teilweise ab. Die Boxen für die einzustellenden Geräte 31,32,33 und 34, die nur als Quader schematisch angedeutet sind, sind daher in der Breite kleiner als die Breite des Einbaumöbels, die durch die Breite des Schrankfaches 40 nach Fig. 2 gegeben ist. Dieses Schrankfach 40 wird durch die Seitenwände 38 und 39, sowie die Deckplatte 41 und die Bodenplatte 42 begrenzt. Zwischen den beiden Seitenblenden 14 und 15 sind die Stirnflächen der Bodenplatte 16 und der Abstellplatten 18,19 und 20 mittels Profilleisten 21,22,23 und 24 abgedeckt. Über dem Gerät 34 schließt die Gitterleiste 25 die Vorderfront des Einbaumöbels bündig ab und läßt eine ausreichende Belüftung der Geräte zu.

Die Seitenplatte 11 ist im Bereich der Außenkante mit der Seitenblende 14 verbunden. In den Eckbereichen zwischen der Seitenblende 14 und der Seitenplatte 11 sind Befestigungsplatten 12 angebracht, auf denen die Schwenkbeschläge 13 und 36 befestigt sind. Das Einbaumöbel wird mit diesen Schwenkbeschlägen 13 und 36 im Bereich der linken vertikalen Vorderkante schwenkbar in dem Schrankfach 40 befestigt.

Die Seitenblende 15, die bis zur Seitenwand 39 des Schrankfaches 40 reicht, steht über die der Schwenkachse abgekehrten Enden der Boden-

- 6 -

platte 16 und der Abstellplatten 18,19 und 20 vor, wie Fig. 1 zeigt. Diese Enden können jedoch auch abgerundet sein, wie anhand der Bodenplatte 16 gezeigt ist. Der Radius ist auf den von der Schwenkachse ausgehenden und bis zur Außenkante der Seitenblende 15 reichenden Schwenkradius bestimmt. Die der Seitenblende 15 zugekehrten Enden können jedoch auch noch mit einer rechten Seitenplatte 37 verbunden sein, wie Fig. 2 zeigt. Die Stirnfläche dieser Seitenplatte 37 ist dann mit dem Bereich der Innenkante der Seitenblende 15 verbunden.

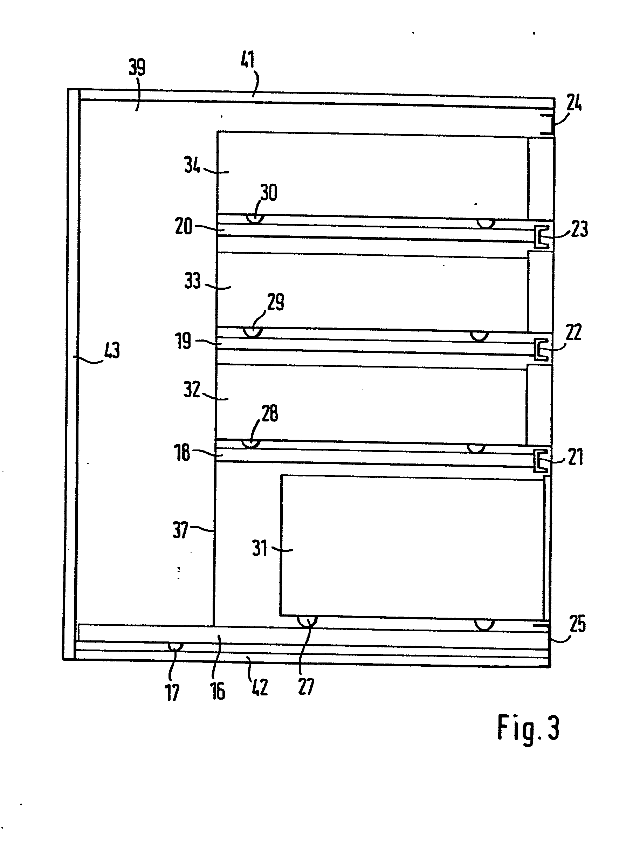

Die linke Seitenplatte 11 kann sich auf der Rückseite über die Bodenplatte 16 und die Abstellplatten 18, 19 und 20 hinaus erstrecken, wie Fig. 1 zeigt. An dem vorstehenden Bereich ist den Boxen zugekehrt eine Mehrfachsteckdose 26 angebracht, an der die in die Boxen eingestellten Geräte angeschlossen werden. Die Geräte 31,32,33 und 34 selbst können durchaus unterschiedliche Tiefe aufweisen, wie Fig. 3 zeigt. Sie werden jedoch so eingestellt, daß ihre Frontplatten bündig mit den Seitenblenden 14 und 15 des Einbaumöbels abschließen. Die Geräte können mittels Füßchen 27,28,29 und 30 auf der Bodenplatte 16 und den Abstellplatten 18,19 und 20 aufgestellt sein. Anstelle der Füßchen lassen sich jedoch auch Laufrollen oder dgl. in den Geräten anbringen.

Die Laufrolle 17 an der Unterseite der Bodenplatte 16 ist im Bereich der hinteren Kante und an dem der Schwenkachse abgekehrten Ende angebracht, damit das Einbaumöbel sich auf dem gesamten Schwenkbereich auf der Bodenplatte 42 des Schrankfaches 40 abstützen kann. Die Bodenplatte 16 und die Seitenwand 11 des Einbaumöbels können durchaus bis zur Rückwand 43 des Schrankfaches 40 reichen. Die Seitenwand 37 an der der Schwenkachse abgekehrten Seite reicht nur über einen Teil der Tiefe des Schrankfaches 40, so daß sie das Ausschwenken des Einbaumöbels nicht behindert. Die Fig. 3 läßt auch den Querschnitt der Profilleisten 21,22,23 und 24 bzw. der Gitterleiste 25 erkennen, die die Stirnflächen der Bodenplatte 16 und der Abdeckplatten 18,19 und 20 zwischen den Seitenblenden 14 und 15 abdecken bzw. den bündigen Abschluß nach oben bringt.

Auf der Vorderseite der Seitenblende 15 ist ein Griffstück 35 angebracht, mit dem das Einbaumöbel aus dem Schrankfach 40 leicht ausgeschwenkt, d.h. herausgezogen werden kann. Dieses Griffstück 35 ist vorzugsweise im unteren Bereich der Seitenblende 15 angebracht.

Für die Schwenkbeschläge 13 und 36 können an sich bekannte zweiteilige Beschläge verwendet werden, wobei jeweils ein Teil am Einbaumöbel und das andere Teil am Schrankfach befestigt werden.

Patentansprüche:

1.  Einbaumöbel für die Geräte einer Hifi-Stereoanlage oder dgl.,
    dadurch gekennzeichnet,
    daß ein zur Vorder- und Rückseite hin offener, in Boxen unterteilter Möbelrahmen (10) im Bereich einer vertikalen Vorderkante oben und unten mit Schwenkbeschlägen (13,36) versehen
    ist.

2.  Einbaumöbel nach Anspruch 1,
    dadurch gekennzeichnet,
    daß der Möbelrahmen (10) aus mindestens einer Seitenplatte (11)
    im Bereich der Schwenkbeschläge (13,36), einer Bodenplatte (16)
    und mehreren, im Abstand übereinander angeordneten Abstellplatten (18,19,20) gebildet ist.

3.  Einbaumöbel nach Anspruch 2,
    dadurch gekennzeichnet,
    daß die Bodenplatte (16) und die Abstellplatte (18,19,20) an
    der Seitenplatte (11) befestigt sind und
    daß die Bodenplatte (16) und die Abstellplatten (18,19,20) an
    der Vorderseite beidseitig mittels vertikaler Seitenblenden
    (14,15) teilweise abgedeckt sind.

4.  Einbaumöbel nach einem der Ansprüche 1 bis 3,
    dadurch gekennzeichnet,
    daß die Bodenplatte (16) auf der der Schwenkachse abgekehrten Seite an der Unterseite im Bereich der hinteren Kante eine
Laufrolle (17) oder dgl. trägt.

5. Einbaumöbel nach einem der Ansprüche 1 bis 4,
dadurch gekennzeichnet,
daß die der Schwenkachse abgekehrte Seitenblende (15) über die
Enden der Bodenplatte (16) und der Abstellplatten (18,19,20)
vorsteht.

6. Einbaumöbel nach einem der Ansprüche 1 bis 5,
dadurch gekennzeichnet,
daß auf der Vorderseite der der Schwenkachse abgekehrten Seitenblende (15) ein Griffstück (35) befestigt ist.

7. Einbaumöbel nach Anspruch 6,
dadurch gekennzeichnet,
daß das Griffstück (35) im unteren Bereich der Seitenblende
(15) angebracht ist.

8. Einbaumöbel nach einem der Ansprüche 1 bis 7,
dadurch gekennzeichnet,
daß die Seitenplatte (11) an der Rückseite über die durch den
Möbelrahmen (10) gebildeten Boxen vorsteht und auf der den
Boxen zugekehrten Innenseite eine Mehrfachsteckdose (26) trägt.

9. Einbaumöbel nach einem der Ansprüche 1 bis 8,
dadurch gekennzeichnet,
daß die vorderen Stirnflächen der Bodenplatte (16) und der
Abstellplatten (18,19,20) zwischen den Seitenblenden (14,15)
mittels Profilleisten (21,22,23,25) abgedeckt sind.

10. Einbaumöbel nach einem der Ansprüche 1 bis 9,
    dadurch gekennzeichnet,
    daß die beiden Seitenblenden (14,15) an ihren oberen Enden
    mittels einer Gitterleiste (24) oder dgl. verbunden sind, die
    die obere Box abteilt.

11. Einbaumöbel nach einem der Ansprüche 1 bis 10,
    dadurch gekennzeichnet,
    daß die Seitenplatte (11) an der Außenkante der zugekehrten
    Seitenblende (14) befestigt ist und
    daß die Schwenkbeschläge (13,36) auf Befestigungsplatten (12)
    angebracht sind, die im Eckbereich zwischen der Seitenplatte
    (11) und der Seitenblende (14) angeordnet sind.

12. Einbaumöbel nach einem der Ansprüche 1 bis 11,
    dadurch gekennzeichnet,
    daß zumindest die Abstellplatten (18,19,20) lösbar mit der
    Seitenplatte (11) verbunden und in unterschiedlichen Abständen
    mit der Seitenplatte (11) verbindbar sind.

13. Einbaumöbel nach Anspruch 1,
    dadurch gekennzeichnet,
    daß die Bodenplatte (16) und die Abstellplatten (18,19,20) an
    den der Schwenkachse abgekehrten Enden entsprechend dem
    Schwenkradius abgerundet sind, der sich aus der Breite des
    Einbaumöbels ergibt und von der Schwenkachse ausgeht.

14. Einbaumöbel nach Anspruch 1,
    dadurch gekennzeichnet,
    daß die der Schwenkachse abgekehrten Enden der Bodenplatte (16)
    und der Abstellplatten (18,19,20) mit einer weiteren Seiten-

- 4 -

platte verbunden sind und

daß an der Stirnseite dieser Seitenplatte (37) die zugekehrte
Seitenblende (15) mit dem Bereich ihrer Innenkante befestigt
ist.

Fig.1

0045347

Fig.2

0045347

Fig.3

Europäisches Patentamt

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | DE – U – 1 702 813 (BEZDECK)<br>* Ansprüche 1 bis 3; Fig. 1 und 2 *<br>-- | |
| A | DE – A1 – 2 551 112 (CARON)<br>* Seite 3, Zeile 16 bis Seite 5,<br>Zeile 12; Fig. 1 bis 3 *<br>---- | |

**KLASSIFIKATION DER ANMELDUNG (Int. Cl.³)**

A 47 B 81/06

H 05 K 7/18

**RECHERCHIERTE SACHGEBIETE (Int. Cl.³)**

A 47 B 81/06

H 05 K 7/18

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

X | Der vorliegende Recherchenbericht wurde für alle Patentansprüche erstellt.

| Recherchenort | Abschlußdatum der Recherche | Prüfer |
|---|---|---|
| Berlin | 21-10-1981 | HAHN |

EPA form 1503.1 08.78